# EUROPÄISCHE PATENTSCHRIFT

(11) **EP 1 380 047 B1**
(45) Veröffentlichungstag und Bekanntmachung des Hinweises auf die Patenterteilung: **01.10.2008**
(21) Anmeldenummer: 02718134.6
(22) Anmeldetag: 14.02.2002
(51) Int. Cl.: H01L 21/285

(54) **VERFAHREN ZUR HERSTELLUNG EINES HALBLEITER-BAUELEMENTS MIT EINER T-FÖRMIGEN KONTAKTELEKTRODE**
METHOD FOR PRODUCING A SEMICONDUCTOR COMPONENT COMPRISING A T-SHAPED CONTACT ELECTRODE
PROCEDE DE PRODUCTION D'UN COMPOSANT SEMI-CONDUCTEUR PRESENTANT UNE ELECTRODE DE CONTACT EN FORME DE T

(30) Priorität: 09.04.2001 DE 10117741
(43) Veröffentlichungstag der Anmeldung: 14.01.2004
(73) Patentinhaber: United Monolithic Semiconductors GmbH, 89081 Ulm (DE)
(72) Erfinder: BEHAMMER, Dag, 89079 Ulm (DE)
(74) Vertreter: Weber, Gerhard
(86) Internationale Anmeldenummer: PCT/EP2002/001587
(87) Internationale Veröffentlichungsnummer: WO 2002/082519

(56) Entgegenhaltungen:
- EP-A- 0 550 317
- EP-A- 0 592 064
- DE-C- 4 211 052
- US-A- 5 399 896
- US-A- 5 817 558

## Beschreibung

Die Erfindung betrifft ein Verfahren zur Herstellung eines Halbleiter-Bauelements mit einer im Querschnitt T-förmigen metallischen Kontaktelektrode, insbesondere eines Feldeffekt-Transistors mit einem T-förmigen Metallgate.

Bei Feldeffekt-Transistoren ist die Gatelänge eine die Grenzfrequenz des Transistors maßgeblich bestimmende Dimension, so daß für hohe Frequenzen eine möglichst geringe Gatelänge angestrebt wird. Andererseits soll auch der Zuleitungswiderstand der Gate-Elektrode möglichst gering sein. Die Merkmale geringer Gatelänge und niedrigen Zuleitungswiderstands sind insbesondere durch metallische Gate-Elektroden mit einem schmalen Gatefuß und einem demgegenüber breiten Gatekopf, sogenannten T-förmigen Elektroden (T-Gate) realisierbar.

Sehr kleine Gatelängen im Submikrometerbereich, insbesondere unter 0,2 µm, sind z. Z. in direkter optischer Lithographie nur in begrenzter Zuverlässigkeit herstellbar.

Aus der Doppelpolysiliziumtechnologie (siehe z. B. T. Sakai et al. Gigabit logic bipolar technology: Advanced super self-aligned technology, Elec. Lett. 19, 283-284,1983) ist es an sich bekannt, die durch die zur Verfügung stehende Lithographie bestimmten kritischen lateralen Dimensionen durch Materialspacer an den Wänden von Lochstrukturen zu unterschreiten.

Dabei werden sogenannte Spacer als deponierte Schicht über eine senkrecht strukturierte Materialstufe und ihre anschließende anisotrope Ätzung definiert. Im Rahmen der Doppelpolysiliziumtechnologie dienen die Spacer nicht nur zur Verkleinerung der Emitterfläche, sondern auch zur Definition der elektrischen Eigenschaften, indem Oxid-, Nitrid- und Polysiliziumspacer kombiniert werden.

In US 4472872 wird die Gatelänge eines GaAs-MESFETs durch Spacer an den Flanken zu den ohmschen Metallkontakten und durch den Abstand der Metallkontakte zueinander bestimmt. Die Höhe der Flanken, an dem die Spacer hergestellt werden, kann durch zusätzliche Hilfsschichten erhöht werden. Eine T-förmige Aufweitung des Gates in einem Gatekopf ist nicht vorgesehen. Nachteilig ist ferner die Spacerätzung auf dem späteren Gatebereich und die angedeutete Entfernung der Spacer selektiv zu den verwendeten Metallen.

In der DE 42 11 052 C1 ist ein Verfahren zur Herstellung eines Feldeffekttransistors mit einem T-Gate beschrieben, bei welchem in einem ersten Lithographieschritt eine Öffnung über dem Halbleitermaterial erzeugt wird. Erste einander zugewandte Spacer an den Seitenflanken der Öffnung dienen als Maske für die Ätzung eines offenen Recessgrabens. Dessen Breite wird durch zweite Spacer weiter eingeengt auf eine Lücke mit der Struktur des Gatefußes. Durch ganzflächige Abscheidung einer Gatemetallisierung und nachfolgende Strukturierung, was den Einsatz einer zweiten Gate-Maske erfordert, wird der erweiterte Gate-Kopf nach Breite und Position festgelegt. Ein ähnliches Verfahren ist in der EP 0 592 064 A2 beschrieben. Durch die unabhängige Strukturierung von Gatefuß und Gatekopf besteht die Gefahr von Positionsierungsfehlern. Nachteilig ist ferner auch hier, daß Ätzvorgänge die Halbleiteroberfläche schädigen und Bauelementeigenschaften verschlechtern können.

Bei einem aus der US 5 399 896 bekannten Verfahren wird zunächst mit einem ersten Spacer (outside spacer) an einer Stufenflanke und mittels einer AI-Implantation ein Recessgraben definiert und an den dabei entstehenden Seitenflanken des Recessgrabens werden einander zugewandt weitere Spacerschichten (inside spacer) erzeugt, deren lateraler Abstand die Gatelänge bestimmt und mit Gatemetall aufgefüllt wird. Die tatsächlich entstehende Gatelänge hängt von den lateralen Abmessungen des ersten und der weiteren Spacer ab, welche wiederum durch die Höhen der jeweiligen vertikalen Stufen beeinflußt sind. Durch die Vielzahl der die Gatelänge beeinflussenden Parameter ist eine schlechte Reproduzierbarkeit der Gatelänge zu erwarten. Nachteilig an dem Verfahren ist ferner, daß bei der zweiten Spacerätzung der Recessboden geschädigt werden kann, was zu einer Verschlechterung der Bauelementeigenschaften führen kann.

In der US 5 817 558 ist ein Verfahren zur Herstellung einer T-förmigen Elektrode eines Feldeffekttransistors beschrieben, bei welcher in einer Schichtenfolge über einem Halbleitersubstrat in einer Siliziumnitridschicht eine erste Öffnung erzeugt wird. An den gegenüber liegenden Kanten dieser ersten Öffnung wird jeweils ein Spacer erzeugt und die Spacer maskieren einen Ätzvorgang in die darunter liegenden Schichten, in welchen eine weite Öffnung mit gegenüber der ersten Öffnung geringer Breite erzeugt wird. Nach Vertiefung der ersten Öffnung und Erzeugen einer Oxidschicht in dem Graben wird amorphes Silizium als Material der T-förmigen Elektrode in die erste und zweite Öffnung eingefüllt.

Bei einem aus der EP 0 550 317 A1 bekannten Verfahren wird in einer über einer Halbleiterschichtenfolge abgeschiedenen ersten Fotolackschicht eine erste, sich nach unten erweiternde Öffnung erzeugt, durch welche in einer darunter liegenden dielektrischen Schicht mittels anisotroper Ätzung eine zweite Öffnung gleicher Weiter erzeugt wird. Nach Entfernen der ersten Fotolackschicht wird eine neue Fotolackschicht aufgebracht, in welcher über der zweiten Öffnung eine dritte, sich nach unten erweiternde Öffnung erzeugt wird. Unterhalb der zweiten Öffnung wird durch deren Unterätzung ein Recess erzeugt. Beim Abscheiden von Gatemetall wird in der zweiten Öffnung und dem darunter befindlichen Recess ein Gatefuß und in der dritten Öffnung in der zweiten Fotolackschicht ein Gatekopf einer T-förmigen Gate-Elektrode erzeugt.

Der Erfindung liegt die Aufgabe zugrunde, ein vorteilhaftes Verfahren zur Herstellung einer T-förmigen Elektrode mit sehr schmalem Elektrodenfuß anzugeben.

Die Erfindung ist im Patentanspruch 1 beschrieben. Die abhängigen Ansprüche enthalten vorteilhafte Ausgestaltungen und Weiterbildungen der Erfindung. Die Erfindung ist nachfolgend anhand des bevorzugten Einsatzes für die Herstellung einer Gateelektrode eines Feldeffekttransistors als Elektrode eines Halbleiterbauelements beschrieben, ohne aber hierauf beschränkt zu sein.

Bei dem erfindungsgemäßen Verfahren erfolgen die Festlegung der Positionen von Gate-Kopf und Gate-Fuß selbstjustierend, so daß keine relativen Ausrichtungsfehler durch nacheinander angewandte Lithographie-Masken entstehen. Die beiden Spacer, welche als Maske für den Gatefuß eingesetzt werden, können in einem Prozeßschritt erzeugt werden, so daß keine Summierung von Dimensionierungsfehlern auftritt. Die Erzeugung der Spacer erfolgt nach aus dem Stand der Technik bekannten Verfahren.

Besonders vorteilhaft ist die Einfügung einer Schutzschicht zwischen den Schichtbereich zur Festlegung der Struktur des Gatekopfes und zur Erzeugung der Spacer einerseits und die Halbleiteroberfläche andererseits, wodurch letztere über weite Strecken des Herstellungsprozesses geschützt ist. Die Schutzschicht wird vorteilhafterweise erst nach der Abscheidung des Gatemetalls entfernt. Vorzugsweise wird ein Recessgraben durch Unterätzung einer solchen Schutzschicht hinter der zweiten Öffnung für den Gatefuß erzeugt. Die Ätzung eines Recessgrabens durch die zweite Öffnung für den Gatefuß ist vorteilhafterweise zugleich der letzte Ätzschritt vor Abscheidung des Gatemetalls für den Gatefuß und vorzugsweise im selben Schritt für den Gatekopf. Sowohl das Abscheiden einer Schutzschicht als auch die Vornahme der Ätzung des Recess-Grabens als letzten Ätzschritt vor der Abscheidung des Gate-Metalls sind auch unabhängig von der vorliegenden besonderen Vorgehensweise zur selbstjustierenden Erzeugung von Gatekopf und Gatefuß vorteilhaft realisierbar.

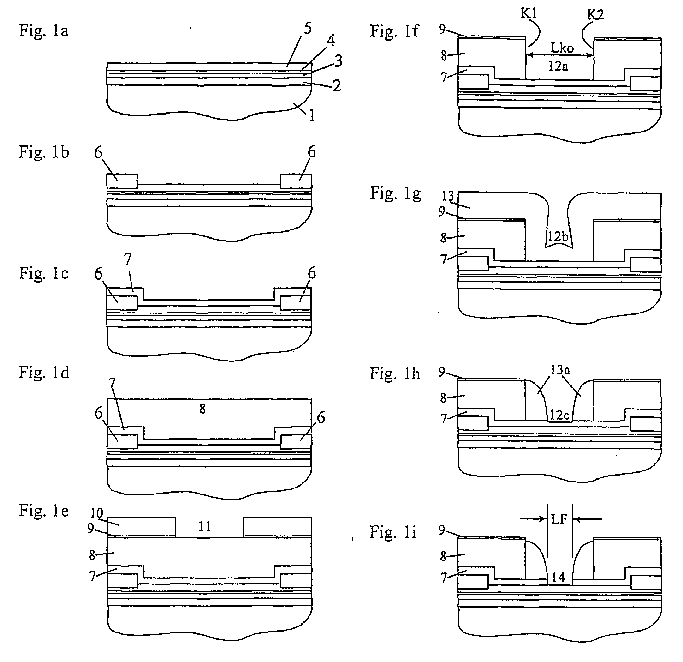

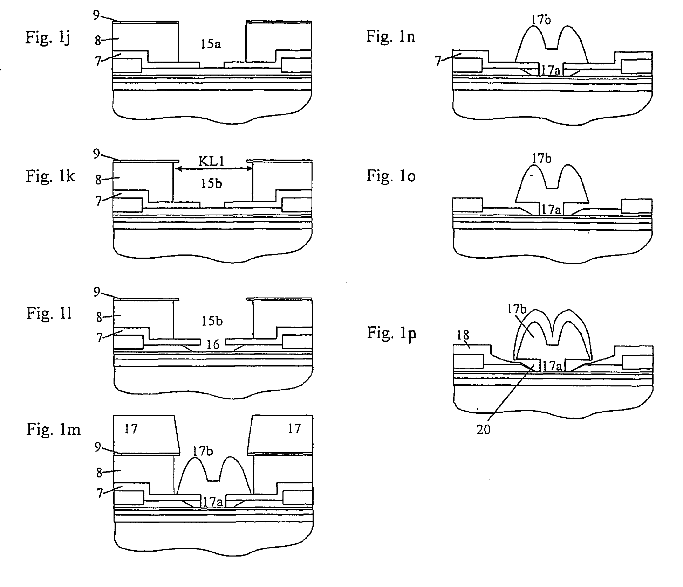

Die Erfindung ist nachfolgend anhand eines bevorzugten Ausführungsbeispiels unter Bezugnahme auf die Abbildungen Fig. 1a bis Fig. 1m, welche aufeinanderfolgende Prozeßschritte zur Herstellung eines HEMT mit selbstjustiertem T-Gate zeigen, eingehend veranschaulicht.

Ausgehend von dem GaAs Substrat 1 definieren die epitaktisch erzeugten Schichten 2 - 5 das Vertikalprofil des Transistors, das in seiner Dicken- und Elementstruktur im Einzelfall auf die jeweilige Anwendung abgestimmt ist. Typischerweise stellt 2 den Buffer dar, 3 bildet das zweidimensionale Elektronengas (der Kanal), 4 ist eine Stopschicht, die zur definierten Ätzung des Recessgrabens beiträgt, und 5 die hochdotierte Kontaktschicht (Fig. 1a). Nach Definition der ohmschen Kontakte 6 für Source und Drain in Fig. 1b erfolgt die PECVD Abscheidung einer Nitrid (Si₃N₄)-Schicht 7 als Schutzschicht (siehe Fig. 1c). Im folgenden (Fig. 1d) wird die temperaturstable Lackschicht 8 (z. B. PMGI, PMMA oder Polyimid) und die Konturschicht 9, vorzugsweise eine anorganische Schicht, aufgebracht, in die durch die Fotolackmasse 10 die Struktur 11 durch reaktives Ionen Ätzen (RIE) übertragen wird (Fig. 1e). Die Maske 9 maskiert dann eine trockenchemische Plasmaätzung der temperaturstabilen Lackschicht 8 und definiert somit die Struktur 12a als erste Öffnung der lateralen Weite LKO mit zwei gegenüberliegenden Materialstufen K1, K2, die sich durch eine hohe Flankensteilheit auszeichnen und keinen Lackfuß am Übergang zur Schutzschicht 7 aufweisen (Fig. 1f). Beide Eigenschaften lassen sich durch an sich bekannte Parametereinstellung der verwendeten RIE Ätzung erzeugen.

Anschließend erfolgt insbesondere mittels einer PECVD eine Abscheidung einer Schicht zur Bildung von Spacern, vorzugsweise einer Oxidschicht 13, die die erste Öffnung 12a und 12b verkleinert (Fig. 1g). Durch die anschließende anisotrope Ätzung der Schicht 13 bilden sich an den Kanten K1, K2 die Spacer 13a aus (Fig. 1h). Die reduzierten Strukturabmaße der Weite LF werden durch eine anisotrope Ätzung mit niedriger Substratschädigung in die Schutzschicht 7 übertragen und bilden mit der zweiten Öffnung 14 in der Schutzschicht 7 (Fig. 1i) eine Maskierung für eine Recessätzung und die Abscheidung der Gatefußmetallisierung. Nach der vorzugsweise naßchemischen Entfernung der Oxidspacer 13a, z. B. in gepufferter Flußsäure, selektiv zu der Zwischenschicht 9, der Lackschicht 8 und der Schutzschicht 7 (Fig. 1k), wird die Lackschicht 8, z. B. in einem isotropen Sauerstoffplasma, maskiert durch die Zwischenschicht 9, zurückgeätzt. Durch die isotrope Ätzung wird das Loch 15a so aufgeweitet, daß mit 15b ein überhängendes Kantenprofil der Weite KL1 entsteht, das die lift-off Qualität der der Recessätzung (Fig. 1l) folgenden Gatemetallisierung (Fig. 1m) wesentlich verbessert. Dabei stellt 17a den Gatefuß, dessen laterale Abmessung durch die Weite LF der zweiten Öffnung gegeben ist, und 17b den Gatekopf, dessen laterale Abmessung durch die Weite LKO in der Konturschicht 9 bestimmt ist, dar. Im folgenden Lift-off-Prozess wird der Fotolack 8 naßchemisch entfernt und hebt dabei die Schichten 9 und 17 ab. Nach Entfernung der Schutzschicht 7 wird der Transistor mit einer Si₃N₄-Schicht passiviert und ggf. durch weitere Schritte mit anderen Bauelementen kontaktiert.

Bei der Passivierung wird günstigerweise der freie Raum 20 unterhalb der seitlichen Überstände des Gatekopfes nicht vollständig mit dem Passivierungsnitrid ausgefüllt. Dadurch wird die Streukapazität zwischen der Gateelektrode und den dieser gegenüberstehenden Bereichen der hochdotierten Kontaktschicht 5 vorteilhaft gering gehalten. Diese Maßnahme ist auch unabhängig von der beschriebenen Herstellung der Gate-Elektrode vorteilhaft.

Die Erfindung ist besonders vorteilhaft für Feldeffekttransistoren in Verbindungshalbleitermaterialien, insbesondere in pseudomorpher oder metamorpher III-V-HEMT-Technologie, wo die Gatelänge und die Weite des Recessgrabens geometrisch besonders kritische laterale Größen unterhalb 0,2 µm sind, wogegen die übrigen lateralen Abmessungen wesentlich größer und unkritischer sind.

Die vorstehend und die in den Ansprüchen angegebenen sowie die den Abbildungen entnehmbaren Merkmale sind sowohl einzeln als auch in verschiedener Kombination vorteilhaft realisierbar. Die Erfindung ist nicht auf die beschriebenen Ausführungsbeispiele beschränkt, sondern im Rahmen fachmännischen Könnens in mancherlei Weise abwandelbar. Insbesondere sind einzelne Materialien oder Materialkombinationen bei Schichten und/oder Ätzmitteln unter Beibehaltung des Erfindungsgedankens einsetzbar.

## Patentansprüche

1. Verfahren zur Herstellung eins Halbleiter-Bauelements mit einer im Querschnitt T-förmigen metallischen Kontaktelektrode, insbesondere eines Feldeffekttransistors mit T-Gate, bei welchem
- in einem Kopf-Lithographie-Schritt eine die Breite und Position des Elektrodenkopfes der T-förmigen Kontaktelektrode bestimmende erste Öffnung (12a, 15a) in einem oberhalb des vorgesehenen Elektrodenfußes liegenden Schichtbereich einer Schichtenfolge über dem Halbleitermaterial mit gegenüberliegenden Kanten (K1, K2) erzeugt wird,
- an den gegenüberliegenden Kanten (K1, K2) je ein Spacer (13a) erzeugt wird,
- die Spacer (13a) als Maske für die Erzeugung einer zweiten die Breite des Elektrodenfußes bestimmenden Öffnung (14) benutzt werden und
- der Elektrodenkopf (17b) in der ersten Öffnung erzeugt wird,
**dadurch gekennzeichnet, dass** die erste Öffnung in einer Kopfschicht (8) und einer über dieser liegenden Konturschicht (9) erzeugt wird, und dass die erste Öffnung (12a) in der Kopfschicht (8) durch Unterätzen der Konturschicht (9) vor Erzeugen des Elektrodenkopfs verbreitert wird.

2. Verfahren nach Anspruch 1, **dadurch gekennzeichnet, daß** die Spacer (13a) vor der Erzeugung des Elektrodenkopfes entfernt werden.

3. Verfahren nach Anspruch 1 oder 2, **dadurch gekennzeichnet, daß** die Struktur der ersten Öffnung (12a) mittels optischer Lithographie festgelegt wird.

4. Verfahren nach einem der Ansprüche 1 bis 3, **dadurch gekennzeichnet, daß** zwischen dem Halbleitermaterial (5) und dem Schichtbereich (8, 9) für die erste Öffnung eine Schutzschicht (7) abgeschieden wird, in welcher die zweite Öffnung (14) erzeugt wird.

5. Verfahren nach einem der Ansprüche 1 bis 4, **dadurch gekennzeichnet, daß** unter der zweiten Öffnung (14) ein Recess-Graben (16) geätzt wird.

6. Verfahren nach Anspruch 5, **dadurch gekennzeichnet, daß** die Ätzung des Recess-Grabens als letzter Schritt vor Erzeugen des Elektrodenfußes vorgenommen wird.

7. Verfahren nach einem der Ansprüche 1 bis 6, **dadurch gekennzeichnet, daß** Elektrodenfuß (17a) und Elektrodenkopf (17b) in einem Verfahrensschritt, insbesondere durch Aufdampfen eines Kontaktelektrodenmetalls hergestellt werden.

8. Verfahren nach einem der Ansprüche 4 bis 8, **dadurch gekennzeichnet, daß** die Schutzschicht (7) nach Fertigstellung der T-förmigen Elektrode entfernt wird und eine abschließende Passivierungsschicht (18) den Raum (20) zwischen Elektrodenkopf (17b) und beabstandet darunter liegendem Halbleitermaterial nicht vollständig ausfüllend aufgebracht wird.

## Claims

1. Method of producing a semiconductor device with a cross-sectionally T-shaped metallic contact electrode, in particular a field-effect transistor with a T gate, in which
- in a head lithography step, a first aperture (12a, 15a), determining the width and position of the electrode head of the T-shaped contact electrode, is created in a layer region of a layer sequence over the semiconductor material with opposing edges (K1, K2) which lies above the intended electrode foot,
- a spacer (13a) is respectively created on the opposing edges (K1, K2),
- the spacers (13a) are used as a mask for the creation of a second aperture (14), determining the width of the electrode foot, and in
- the electrode head (17b) is created in the first aperture **characterized in that** the first opening is created in a head layer (8) and a contour layer (9) lying over the latter, and **in that** the first aperture (12a) in the head layer (8) is widened by undercutting the contour layer (9) by etching before creating the electrode head.

2. Method according to Claim 1, **characterized in that** the spacers (13a) are removed before the creation of the electrode head.

3. Method according to Claim 1 or 2, **characterized in that** the structure of the first aperture (12a) is fixed by means of optical lithography.

4. Method according to one of Claims 1 to 3,
**characterized in that** a protective layer (7), in which the second aperture (14) is created, is deposited between the semiconductor material (5) and the layer region (8, 9) for the first aperture.

5. Method according to one of Claims 1 to 4,
**characterized in that** a recess trench (16) is etched under the second aperture (14).

6. Method according to Claim 5, **characterized in that** the etching of the recess trench is performed as the final step before creating the electrode foot.

7. Method according to one of Claims 1 to 6,
**characterized in that** the electrode foot (17a) and the electrode head (17b) are produced in one method step, in particular by vapour-depositing a contact electrode metal.

8. Method according to one of Claims 4 to 8,
**characterized in that** the protective layer (7) is removed after completion of the T-shaped electrode, and a terminating passivation layer (18) is applied, not completely filling the space (20) between the electrode head (17b) and the semiconductor material lying at a distance thereunder.

## Revendications

1. Procédé de production d'un composant semi-conducteur comportant une électrode de contact métallique présentant une section transversale en forme de T, en particulier d'un transistor à effet de champ avec une grille en T, dans lequel
- on produit, dans une étape de lithographie de tête, une première ouverture (12a, 15a), avec des arêtes opposées (K1, K2), déterminant la largeur et la position de la tête d'électrode de l'électrode de contact en forme de T dans une zone de couche située au-dessus du pied d'électrode prévu d'une suite de couches au-dessus du matériau semi-conducteur,
- on produit un écarteur (13a) à chacune des arêtes opposées (K1, K2),
- on utilise les écarteurs (13a) comme masque pour la production d'une deuxième ouverture (14) déterminant la largeur du pied d'électrode, et
- on produit la tête d'électrode (17b) dans la première ouverture,
**caractérisé en ce que** l'on produit la première ouverture dans une couche de tête (8) et une couche de contour (9) située au-dessus de celle-ci, et **en ce que** l'on élargit la première ouverture (12a) dans la couche de tête (8) par gravure sous-jacente de la couche de contour (9) avant de produire la tête d'électrode.

2. Procédé selon la revendication 1, **caractérisé en ce que** l'on enlève les écarteurs (13a) avant la production de la tête d'électrode.

3. Procédé selon la revendication 1 ou 2,
**caractérisé en ce que** l'on fixe la structure de la première ouverture (12a) par lithographie optique.

4. Procédé selon l'une quelconque des revendications 1 à 3, **caractérisé en ce que** l'on dépose, entre le matériau semi-conducteur (5) et la zone de couche (8, 9) pour la première ouverture, une couche de protection (7) dans laquelle on produit la deuxième ouverture (14).

5. Procédé selon l'une quelconque des revendications 1 à 4, **caractérisé en ce que** l'on grave une fosse en retrait (16) en dessous de la deuxième ouverture (14).

6. Procédé selon la revendication 5, **caractérisé en ce que** l'on effectue la gravure de la fosse en retrait comme dernière étape avant la production du pied d'électrode.

7. Procédé selon l'une quelconque des revendications 1 à 6, **caractérisé en ce que** l'on réalise le pied d'électrode (17a) et la tête d'électrode (17b) en une étape de procédé, notamment en vaporisant un métal d'électrode de contact.

8. Procédé selon l'une quelconque des revendications 4 à 8, **caractérisé en ce que** l'on enlève la couche de protection (7) après l'achèvement de l'électrode en forme de T et on dépose une couche finale de passivation (18) qui ne remplit pas entièrement l'espace (20) entre la tête d'électrode (17b) et le matériau semi-conducteur situé à distance en dessous.
